# EUROPEAN PATENT APPLICATION

(11) **EP 4 821 734 A1**
(43) Date of publication of application: **14.10.2026**
(21) Application number: 25798275.1
(22) Date of filing: 06.02.2025
(51) Int. Cl.: B60K 35/23, B60K 35/40, B60K 35/50, G02B 27/01

(54) **HEAD-UP DISPLAY**

(30) Priority: 30.04.2024 KR 20240057788
(71) Applicant: LG Electronics Inc., Yeongdeungpo-gu Seoul 07336 (KR)
(72) Inventor: KWEON, Ohjin, Seoul 07796 (KR); RO, Sukju, Seoul 07796 (KR); YOON, Kyoungsang, Seoul 07796 (KR); JO, Sangwon, Seoul 07796 (KR)
(74) Representative: Vossius & Partner Patentanwälte Rechtsanwälte mbB
(86) International application number: PCT/KR2025/099339
(87) International publication number: WO 2025/230386

(57) **Abstract**

The present embodiment comprises a main body; the main body comprising a housing having an inner space formed in the housing; a screen accommodated in the inner space and reflecting light; and a cover disposed above the screen, wherein the cover comprises a polarizing film and a quarter-wave plate disposed on a lower surface of the polarizing film.

## Description

### [Technical Field]

The present invention relates to a head-up display.

### [Background Art]

A head-up display is a device installed in a vehicle that emits image light toward the windshield of vehicle. A vehicle head-up display can display various information, including driving information, while the vehicle is in motion.

A head-up display comprises a display panel that generates and outputs image light, and at least one mirror that reflects the image light generated by the display panel.

The image light generated by the display panel may be incident on the windshield of vehicle by the mirror, allowing the driver to perceive a virtual image in front of the windshield.

Republic of Korea Patent No. 10-2467924 B1 November 17, 2022 discloses a vehicle head-up display.

The vehicle head-up display comprises a housing having an inner space formed therein and disposed below the windshield; an imaging device accommodated in the inner space and emitting first linearly polarized light in a first direction; an inner mirror disposed in an inner space, spaced apart from an image device, that reflects first linearly polarized light in a first direction emitted from the image device; a polarizing film that transmits the first linearly polarized light reflected from the inner mirror and reflects second linearly polarized light in a second direction orthogonal to the first direction; and a phase retardation mirror disposed outside the inner space, that phase-converts the first linearly polarized light reflected from the inner mirror and then transmitted through the polarizing film into second linearly polarized light and then outputs the converted light to the polarizing film, the second linearly polarized light emitted from the phase retardation mirror is reflected onto a windshield by the polarizing film, and the first linearly polarized light reflected from the inner mirror passes through the polarizing film and then heads toward the windshield.

### [Disclosure]

### [Technical Problem]

The present embodiment provides a head-up display capable of minimizing diffuse images caused by reflection of sunlight.

### [Technical Solution]

A head-up display according to the present embodiment comprises a main body; the main body comprising a housing having an inner space formed in the housing; a screen accommodated in the inner space and configured to reflect light; and a cover disposed above the screen.

The cover comprises a polarizing film and a quarter-wave plate disposed on a lower surface of the polarizing film.

The cover further may comprise a dust cover.

The polarizing film may be disposed on a lower surface of the dust cover.

The dust cover may be transparent.

A lower surface of the quarter-wave plate may be vertically spaced from an upper surface of the screen.

The polarizing film may be disposed to absorb S waves of incident sunlight and transmit P waves.

The quarter-wave plate may convert P waves transmitted through the polarizing film into circularly polarized light, and convert circularly polarized light reflected from the screen into S waves.

An anti-reflection layer may be formed on an upper surface of the screen.

The anti-reflection layer may be an aluminum coating layer.

The screen may comprise a Fresnel layer having a Fresnel pattern formed on a lower surface of the Fresnel layer; a mirror formed on the Fresnel pattern; and a diffusion layer formed on an upper surface of the Fresnel layer.

The anti-reflection layer may be formed on an upper surface of the diffusion layer.

The main body may further comprise a top cover disposed on the upper portion of the housing and having an opening.

The cover may be disposed in the opening.

The head-up display may further comprise a mirror bench disposed between the main body and a windshield and configured to absorb sunlight.

An upper opening through which light reflected from the screen passes may be formed in the mirror bench.

The cover may be disposed toward the mirror bench.

### [Advantageous Effect]

According to the present embodiment, a cover disposed above the screen comprises a polarizing film and a quarter-wave plate disposed on the lower surface of the polarizing film, this simple structure minimizes diffused images caused by sunlight reflection.

Furthermore, the polarizing film is disposed on the lower surface of the dust cover, minimizing contamination of the polarizing film.

Furthermore, an anti-reflection layer formed on the upper surface of the screen can lower the reflectivity of the screen and reduce the brightness of sunlight reflected from the surface by the screen.

Furthermore, a mirror bench disposed between the main body and the windshield absorbs sunlight, minimizing sunlight incident on the cover.

Furthermore, light reflected from the screen may pass through the upper opening formed in the mirror bench and be directed to the windshield.

### [Description of Drawings]

Fig. 1 is a view illustrating a head-up display according to an embodiment of the present invention,
Fig. 2 is a cross-sectional view of the screen illustrated in Fig. 1,
Fig. 3 is a view illustrating the path of light generated by the image generating unit illustrated in Fig. 1,
Fig. 4 is a view illustrating the path of sunlight incident on a head-up display according to an embodiment of the present invention,
Fig. 5 is a view illustrating a windshield when sunlight is incident, as a comparative example compared to the present embodiment.

### [Best Mode]

Hereinafter, specific embodiments of the present invention will be described in detail with reference to the drawings.

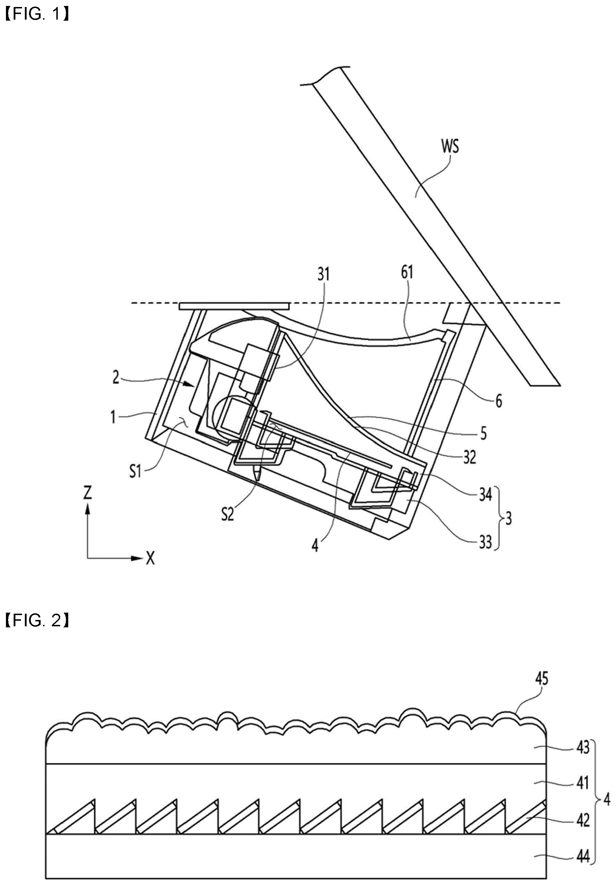

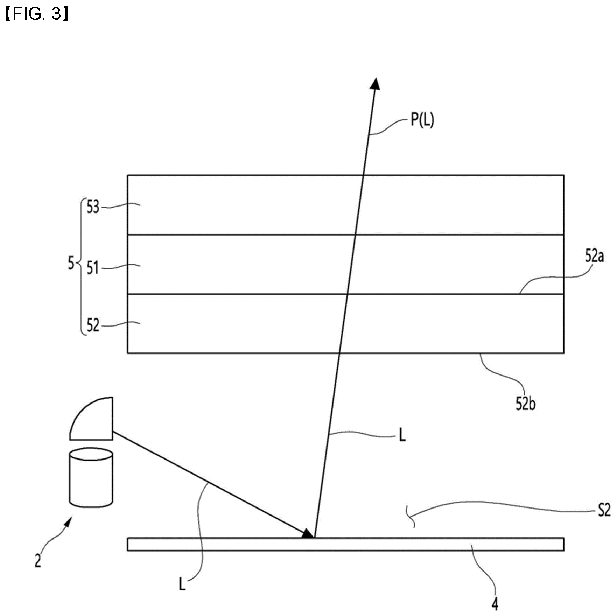

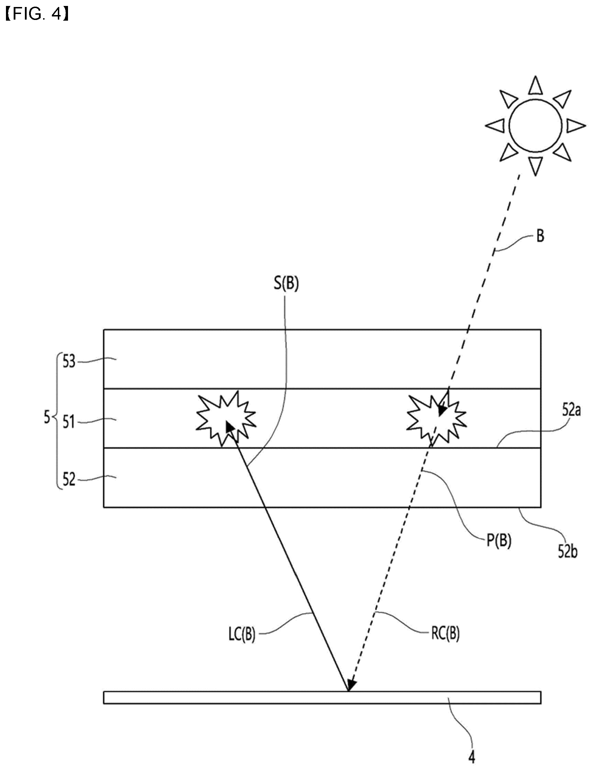

Fig. 1 is a view illustrating a head-up display according to an embodiment of the present invention, Fig. 2 is a cross-sectional view of the screen illustrated in Fig. 1, Fig. 3 is a view illustrating the path of light generated by the image generating unit illustrated in Fig. 1 and Fig. 4 is a view illustrating the path of sunlight incident on a head-up display according to an embodiment of the present invention.

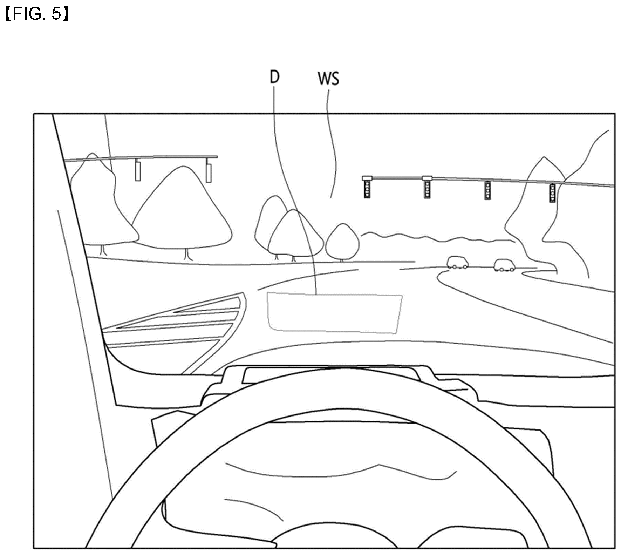

Fig. 5 is a view illustrating a windshield when sunlight is incident, as a comparative example compared to the present embodiment.

A head-up display may be placed on a dashboard 1. The head-up display may be accommodated in a dashboard space S1 formed inside the dashboard 1.

The head-up display may comprise a picture generation unit 2, a main body 3, a screen 4, and a cover 5.

The picture generation unit 2 may be disposed outside the main body 3. The picture generation unit 2 may be disposed on the front, rear, left, or right side of the main body 3. Hereinafter, the picture generation unit 2 will be described as being disposed on the front surface of the main body 3.

The picture generation unit 2 may generate an image and project it toward the screen 4.

An example of an image generating unit 2 may comprise a light source that generates light, an image generator that receives the light generated by the light source and generates image light, and a projection optical module that projects the image light generated by the image generator onto a screen 4.

An example of the light source may comprise an LED light source.

An example of the image generator may comprise a digital micromirror device.

The projection optical module may comprise at least one projection lens and a reflective mirror that reflects light transmitted through the projection lens onto the screen 4.

The image generating unit 2 may be applied to any device that can project an image toward the screen 4.

Hereinafter, the image light emitted from the image generating unit 2 will be referred to as "light."

The main body 3 may be formed with a transmission portion 31 through which light emitted from the image generating unit 2 passes. The transmission portion 31 may be formed in a region of the main body 3 facing the image generating unit 2. A transmission portion 31 may be formed on the front portion of the main body 3. The transmission portion 31 may be a front opening formed on the front portion of the main body 3.

An opening 32 may be formed on the upper surface of the main body 3.

The main body 3 may be composed of a combination of a plurality of members.

The main body 3 may comprise a housing 33.

An inner space S2 may be formed within the housing 33. The housing 33 may protect the screen 4.

The main body 3 may further comprise a top cover 34.

The top cover 34 may be disposed on top of the housing 33. An opening 32 may be formed in the top cover 34.

The main body 3 is not limited to including the housing 33 and the top cover 34, and may also comprise additional components.

The screen 4 may be accommodated in the inner space S2. The screen 4 can be protected by the housing 33.

The upper surface of the screen 4 may face the windshield WS. The lower surface of the screen 4 may face the lower portion of the housing 33.

Light L may be imaged on the screen 4. The screen 4 may reflect the light L. The light L reflected from the screen 4 may pass through the opening 32 and then face the windshield WS.

As illustrated in FIG. 2, the screen 4 may comprise a Fresnel layer 41 having a Fresnel pattern formed on the lower surface of the Fresnel layer 41; a mirror 42 formed on the Fresnel pattern; and a diffusion layer 43 formed on the upper surface of the Fresnel layer 41.

The Fresnel pattern can be formed by a plurality of concentric grooves.

The plurality of concentric grooves may have different sizes, be formed sequentially, and have a shape corresponding to the curvature of the windshield WS.

The plurality of concentric grooves may be formed by alternating peaks and valleys.

The peaks may become gradually smaller as they move downward. The peaks may have an inverted triangular shape.

One surface of the peak may be an inclined surface. The other surface of the peak may be an inclined surface or a vertical surface. One surface of the peak and the other surface of the peak may be formed alternately.

The mirror 42 may be formed on the lower surface of the Fresnel layer 41. The mirror 42 may be formed by coating.

The mirror 42 may be a coating layer formed on one surface of the peak. The mirror 42 may be inclined relative to the vertical surface.

The mirror 42 may be formed on one side surface of the peak and accommodated in the valley.

A diffusion layer 43 may be formed on the upper surface of the Fresnel layer 41. The diffusion layer 43 may be integrated with the Fresnel layer 41.

The diffusion layer 43 may comprise a diffusing pattern. The diffusion layer 43 may allow the screen 4 to comprise a diffuser.

The screen 4 may further comprise an absorption layer 44 that absorbs light.

The absorption layer 44 may be formed on the lower end of the Fresnel layer 41. The absorption layer 44 may contact each of the lower ends of the plurality of peaks and may have a shape connecting the lower ends of the plurality of peaks.

An anti-reflection layer 45 may be formed on the upper surface of the screen 4.

The anti-reflection layer 45 may be formed on the upper surface of the diffusion layer 43.

An example of the anti-reflection layer 45 may be an aluminum coating layer on the upper surface of the diffusion layer 43. The anti-reflection layer 45 may be integrated with the screen 4.

An aluminum coating layer formed on the upper surface of the screen 4 can reduce the surface reflectivity of the screen 4.

When an aluminum coating layer is formed on the upper surface of the screen 4, the surface reflectivity can be reduced from 4 to 5% to 0.5%.

An aluminum coating layer formed on the upper surface of the diffusion layer 43 can reduce the reflectivity of the screen 4, and the brightness of sunlight B reflected on the surface by the screen 4 can be reduced. The aluminum coating layer formed on the upper surface of the diffusion layer 43 can reduce the brightness of sunlight B by 1/8 to 1/10.

The reflection of sunlight B may be minimized by the anti-reflection layer 45.

The cover 5 may be disposed on the upper side of the screen 4. The cover 5 may be disposed in the opening 32. The cover 5 may be disposed in the opening 32 and cover the inner space S2.

The cover 5 can prevent foreign substances such as dust from penetrating the inner space S2.

The cover 5 can protect the screen 4 from the upper side of the screen 4.

The cover 5 may be configured to minimize reflection of sunlight B.

As illustrated in FIGS. 3 and 4, the cover 5 may comprise a polarizing film 51 and a quarter-wave plate 52. The cover 5 may further comprise a dust cover 53.

The polarizing film 51 may be disposed on the lower surface of the dust cover 53.

The polarizing film 51 may be disposed between the dust cover 53 and the quarter-wave plate 52.

As illustrated in FIG. 4, sunlight B may be incident on the polarizing film 51, and the polarizing film 51 may be disposed to absorb S waves of the incident sunlight B and transmit P waves P of the sunlight B.

The quarter-wave plate 52 may be a birefringent material sheet in which light associated with a greater refractive index is delayed by 90° relative to light associated with a lower refractive index.

The quarter-wave plate 52 may be used to convert linearly polarized light into circularly polarized light.

The quarter-wave plate 52 may be disposed on the lower surface of the polarizing film 51.

The upper surface 52a of the quarter-wave plate 52 may be disposed on the lower surface of the polarizing film 51.

The lower surface 52b of the quarter-wave plate 52 may be spaced apart from the upper surface of the screen 4 in the vertical direction Z.

The quarter-wave plate 52 may convert P waves P transmitted through the polarizing film 51 into circularly polarized light.

The quarter-wave plate 52 may convert circularly polarized light reflected from the screen 4 into S waves.

The dust cover 53 may be transparent. The upper surface of the dust cover 53 may be the upper surface of the screen 4. The lower surface of the dust cover 53 may be disposed on the upper surface of the polarizing plate 41.

The dust cover 53 may protect the polarizing plate 51.

The head-up display may further comprise a mirror bench 6, as illustrated in FIG. 1.

The mirror bench 6 may be disposed between the main body 3 and the windshield WS and may absorb sunlight B.

An example of the mirror bench 6 may be accommodated in the space S1 of the dashboard 1. The mirror bench 6 may be disposed between the upper surface of the dashboard 1 and the main body 3.

The other example of the mirror bench 6 may be disposed on the upper surface of the dashboard 1. In this case, the mirror bench 6 may be mounted on the upper surface of the dashboard 1 and absorb sunlight B between the dashboard 1 and the windshield WS.

An upper opening 61 may be formed in the mirror bench 6. The upper opening 61 may be open in the vertical direction Z.

Some of the sunlight B passing through the windshield WS may be absorbed by the mirror bench 6, and the remainder of the sunlight B may be incident on the cover 5.

The cover 5 may face the mirror bench 6.

The operation of the present embodiment will now be described.

The light L emitted from the image generating unit 2 may be unpolarized light, and, as illustrated in FIG. 3, may be emitted into the inner space S2 and imaged on the screen 4 accommodated in the inner space S2.

The screen 4 may reflect light L, and the light L may pass through the 1/4 wavelength plate 52 and then be incident on the polarizing plate 51. S waves among the light L incident on the polarizing plate 51 may be absorbed by the polarizing plate 51, and P waves P may pass through the polarizing plate 51.

The P waves P that pass through the polarizing plate 51 may pass through the dust cover 53, pass through the upper opening 61 of the mirror bench 6, and face the windshield WS.

Meanwhile, sunlight B that passes through the windshield WS may be incident on the head-up display, and some of the sunlight B may be absorbed by the bench 6 in advance, and the remainder that is not absorbed by the mirror bench 6 may be incident on the cover 5, as illustrated in FIG. 4.

Sunlight B incident on the cover 5 may pass through the dust cover 53 and then be incident on the polarizing plate 51 and S wave of the sunlight B may be absorbed by the polarizing plate 51, and the P wave P of the sunlight B may pass through the polarizing plate 51.

The P wave P of the sunlight B that has passed through the polarizing plate 51 may be incident on the quarter-wave plate 52.

The P wave P of the sunlight B may be converted into right-circular polarization RC by the quarter-wave plate 52, and the right-circular polarization RC may be incident on the screen 4.

The right-circular polarization RC incident on the screen 4 may be reflected by the screen 4 on which the anti-reflection layer 44 is formed.

Sunlight B reflected by the screen 4 formed with the anti-reflection layer 44 may be left-circularly polarized LC, and the left-circularly polarized light LC may be incident on a quarter-wave plate 52.

The left-circularly polarized light LC may be converted into an S wave S by the quarter-wave plate 52, and the S wave S may be absorbed by the polarizing plate 51, minimizing the amount of sunlight B transmitted through the dust cover 53.

The polarizing plate 51 and the quarter-wave plate 52 constituting the cover 4 and the screen 5 formed with the anti-reflection layer 44 may reflect the brightness of diffusely reflected sunlight B to 15% or less.

The comparative example is an example in which the cover 5 comprises only the dust cover 53 and the screen 4 does not have an anti-reflection layer 44. The comparative example may have a configuration identical or similar to that of the present embodiment except for the polarizing film 51, the quarter-wave plate 52, and the anti-reflection layer 44.

In this case, sunlight B may pass through the windshield WS and the dust cover 53 of the comparative example, and then be reflected by the screen 4 of the comparative example.

The sunlight B may be unpolarized, pass through the dust cover 53 of the comparative example, and then be surface-reflected by the screen 4 of the comparative example, and the sunlight B surface-reflected by the screen 4 of the comparative example may then pass through the dust cover 53 of the comparative example and face the windshield WS.

The sunlight reflected by the screen 4 of the comparative example may be diffused and blurry in some areas of the windshield WS, and the passenger may perceive a diffused image D as illustrated in FIG. 5, and the diffused image D may obstruct the passenger's view.

On the other hand, in the present embodiment, the sunlight B is partially absorbed by the mirror bench 6, and the remainder of the sunlight B may be minimized by the polarizing plate 51, the quarter-wave plate 52, and the anti-reflection layer 44, and the diffused image D as illustrated in FIG. 5 may be minimized on the windshield WS.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. A head-up display comprising:
a main body; the main body comprising a housing having an inner space formed in the housing;
a screen accommodated in the inner space and configured to reflect light; and
a cover disposed above the screen,
wherein the cover comprises a polarizing film and
a quarter-wave plate disposed on a lower surface of the polarizing film.

2. The head-up display of claim 1,
wherein the cover further comprises a dust cover,
and the polarizing film is disposed on a lower surface of the dust cover.

3. The head-up display of claim 2,
wherein the dust cover is transparent.

4. The head-up display of claim 2,
wherein a lower surface of the quarter-wave plate is vertically spaced from an upper surface of the screen.

5. The head-up display of claim 2,
wherein the polarizing film is disposed to absorb S waves of incident sunlight and transmit P waves.

6. The head-up display of claim 2, wherein the quarter-wave plate converts P waves transmitted through the polarizing film into circularly polarized light, and converts circularly polarized light reflected from the screen into S waves.

7. The head-up display of claim 1, wherein an anti-reflection layer is formed on an upper surface of the screen.

8. The head-up display of claim 7, wherein the anti-reflection layer comprises an aluminum coating layer.

9. The head-up display of claim 7, wherein the screen comprises:
a Fresnel layer having a Fresnel pattern formed on a lower surface of the Fresnel layer;
a mirror formed on the Fresnel pattern; and
a diffusion layer formed on an upper surface of the Fresnel layer, and
wherein the anti-reflection layer is formed on the upper surface of the diffusion layer.

10. The head-up display of claim 1,
wherein the main body further comprises a top cover disposed on an upper portion of the housing and having an opening, and
wherein the cover is disposed in the opening.

11. The head-up display of claim 1, further comprises a mirror bench disposed between the main body and a windshield and configured to absorb sunlight.

12. The head-up display of claim 11, wherein an upper opening through which light reflected from the screen passes is formed in the mirror bench.

13. The head-up display of claim 11, wherein the cover faces the mirror bench.
